Europäisches Patentamt

European Patent Office

Office européen des brevets

(19)

(11) Publication number: **0 155 576**
**B1**

(12) **EUROPEAN PATENT SPECIFICATION**

(45) Date of publication of patent specification: **01.06.88**

(51) Int. Cl.⁴: **H 01 L 29/167**

(21) Application number: **85102333.3**

(22) Date of filing: **01.03.85**

(54) **Radiation-resistant semiconductor device.**

(30) Priority: **02.03.84 JP 38595/84**

(43) Date of publication of application:
**25.09.85 Bulletin 85/39**

(45) Publication of the grant of the patent:
**01.06.88 Bulletin 88/22**

(84) Designated Contracting States:
**DE FR GB SE**

(56) References cited:
**FR-A-2 189 876**

(73) Proprietor: **HITACHI, LTD.**
**6, Kanda Surugadai 4-chome Chiyoda-ku**
**Tokyo 100 (JP)**

(72) Inventor: **Sakurai, Hiroshi**
**2163, Narita-machi Oharai-machi**
**Higashiibaraki-gun Ibaraki-ken (JP)**

(74) Representative: **Patentanwälte Beetz sen. -**
**Beetz jun. Timpe - Siegfried - Schmitt-Fumian**
**Steinsdorfstrasse 10**
**D-8000 München 22 (DE)**

Courier Press, Leamington Spa, England.

**Description**

Background of the invention
Field of the invention:

The present invention relates to a semiconductor device, and more particularly to a radiation-resistant semiconductor device which is improved in point of the degradation of characteristics ascribable to radiation.

Description of the prior art:

In recent years, owing to the progress of integrated circuit technology, semiconductor devices have been remarkably extensively applied to office automation or industrial electronic equipment, robots etc. in the form of microcomputers.

Most of conventional semiconductor integrated circuits operate normally under only environments similar to ordinary dwellings. They cannot be used under an environment such as outer space where radiations pour in ultrahigh vacuum or a severe environment such as the surroundings of a nuclear reactor where the generation of radiations is involved.

However, there are great needs for semiconductor devices of reinforced resistances to radiations in the field of space technology forming future industries, and also for semiconductor devices usable for a robot for inspecting a nuclear reactor, a sensor for monitoring the interior of a nuclear reactor, and so forth.

Radiation environments where semiconductor devices are used are as mentioned below.

(1) Outer space—Radiations principally include proton rays and electron rays. They are classified into the three sorts of solar cosmic rays of high energy particles whose main constituents are proton rays and a small amount of alpha rays, trapped radiations whose main constituents are electron rays having energy of at least 2 MeV and proton rays having energy of at least 6 MeV, and galactic cosmic rays which consist of 85% of protons and about 15% of alpha particles.

(2) Atomic energy facilities—Radiations principally include gamma rays and neutron rays (fast neutrons, thermal neutrons).

It is known that, when irradiated with radiations, a semiconductor device or a semiconductor integrated circuit undergoes such influences as follows, depending upon the sorts etc. of the radiations:

(1) Damage or degradation which is ascribable to steady ionization radiation defined by an integral dose,

(2) damage or degradation and the generation of current hampering an operation, which are ascribable to transient ionization radiation defined by a dose rate,

(3) transitory malfunction which is ascribable to a single particle, e.g., alpha particle or proton, and

(4) the damage or degradation of a material which is ascribable to fast neutrons.

Therefore, a semiconductor device for use in the fields of cosmic radiations such as solar cosmic rays, trapped radiations and galactic cosmic rays or in atomic energy facilities such as nuclear power stations and reprocessing plants should desirably be a semiconductor device of reinforced resistances to radiations, which has the feature that the aforementioned influences of the radiation irradiation are almost negligible, and the development of which is of urgent necessity.

The developments of radiation-resistant semiconductor devices have been performed on a MOS (Metal Oxide Semiconductor) type or bipolar type semiconductor device made of silicon and a compound-semiconductor device made of, e.g., gallium-arsenic. However, they have chiefly been based on the aspect of a process such as the condition of forming an oxide film or the aspect of device design such as the betterment of an integrated circuit, and they have merely adapted an expedient in which the optimum condition is found by trial and error. A technique applicable to all semiconductor devices has not been developed.

'IEEE Transactions of Nuclear Science', Vol. NS-30, No. 6, December 1983, pp. 4224—4228 discloses a 16k-BIT MNOS EAROM produced under the optimum conditions in accordance with the conventional expedient.

Summary of the invention

An object of the present invention is to provide a radiation-resistant semiconductor device which is improved in point of the degradation of characteristics ascribable to radiation.

Another object of the present invention is to provide a radiation-resistant semiconductor device which suffers no degradation of characteristics even when irradiated with radiation.

According to the present invention a semiconductor region of the p- or n-conductivity type in a semiconductor body is formed by doping it with an impurity element which is enriched in an isotope of smaller thermal neutron absorption cross section.

Regarding the impurity the thermal neutron absorption cross section of which is smaller, antimony Sb having a mass number of 123 is mentioned as an n-type impurity, namely, donor, while boron B having a mass number of 11, gallium Ga having a mass number of 69 and indium In having a mass number of 113 are mentioned as p-type impurities, namely, acceptors. Among the isotopes of identical elements, they are ones of smaller thermal neutron absorption cross sections. Besides, the impurities of smaller thermal neutron absorption cross sections include phosphorus P and bismuth Bi as donors and aluminum Al as an

acceptor, and these elements P, Bi and Al can be used in combination with the aforementioned elements Sb, B, Ga and In. The elements should preferably consist only of the isotopes of smaller thermal neutron absorption cross sections.

The fundamental idea of this invention consists in the following. In the neighborhood of a nuclear reactor where neutron rays exist, an impurity element with which a semiconductor body is doped causes nuclear transformation due to, e.g., the (n, γ) reaction in which a neutron enters to emit a gamma ray or the (n, α) reaction in which a neutron enters to emit an alpha way. As result, an impurity concentration changes by way of example, and expected characteristics become different. Accordingly, when an isotope the nuclear reaction cross section of which is small for a nuclear reaction to be noted, for example, the (P, 2P) or (n, α) reaction is employed, the degradation of characteristics attributed to the nuclear transformation can be alleviated. This idea is applicable to all semiconductor devices.

Brief description of the drawings

Figure 1 is a schematic sectional view showing a MOS transistor which is an embodiment of the present invention;

Figure 2 is a graph showing the relationship of the fluctuation $\Delta V_{TH}$ of a threshold voltage versus the dispersion of the quantity $N_x$ of an impurity element mixed in a silicon body;

Figure 3 is a graph showing the computed results of the situations of the variation of the number of boron atoms versus the time of irradiation with thermal neutrons;

Figure 4 is a graph showing the relationships of the shift magnitude of a threshold voltage versus the number of boron atoms within a silicon body before thermal neutron irradiation in the case where the number of boron atoms is decreased by 20% under the irradiation with thermal neutrons;

Figure 5 is a schematic sectional view showing a composite bipolar transistor which is a second embodiment of the present invention;

Figure 6 is an equivalent circuit diagram of the composite transistor in Figure 5;

Figure 7 is a graph showing the relationships between the drift mobilities of a hole and an electron in a silicon body and the impurity concentration; and

Figure 8 is a graph showing the relationships between the resistivities of p-type and n-type silicon regions and the impurity concentration.

Description of the preferred embodiments

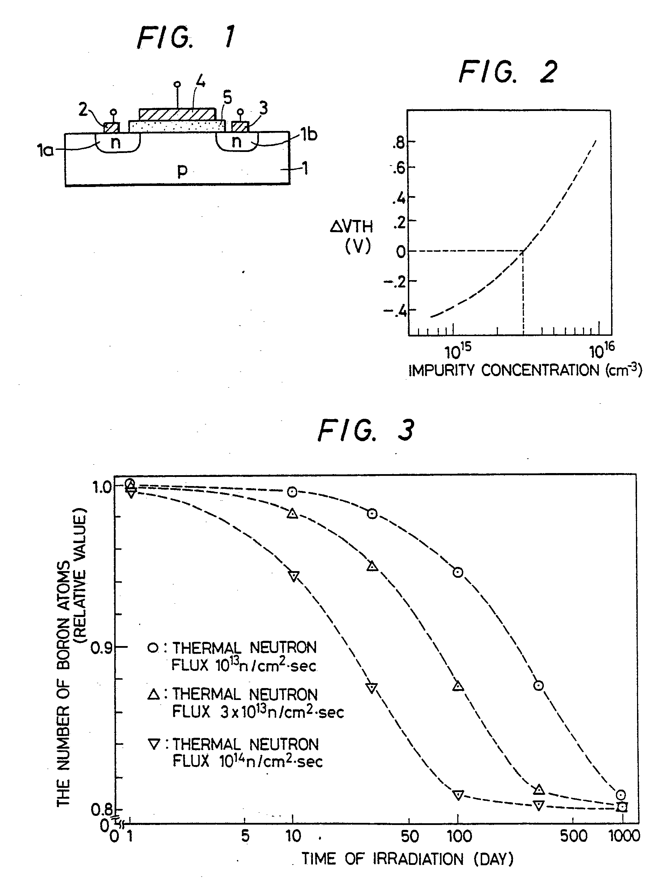

Referring to Figure 1, numeral 1 designates a p-type silicon substrate, which is doped with a donor thereby to form an n-type source region 1a and an n-type drain region 1b. A source electrode 2 and a drain electrode 3 are respectively held in ohmic contact with the source region 1a and the drain region 1b. A gate electrode 4 is disposed through a silicon oxide film 5 on the surface of the silicon substrate 1 between the source and drain regions 1a, 1b. Thus, an n-channel type MOS transistor is constructed.

In this embodiment, the silicon substrate 1 is doped with boron B, the mass number of which is 11 in accordance with the present invention. The donor used for forming both the source and drain regions 1a, 1b is phosphorus P.

It is well known that the carriers of currents in a semiconductor are conduction electrons and holes, which are created by doping a silicon crystal refined to a high purity, with a slight amount of foreign element (impurity element). More specifically, in a case where a silicon crystal is doped with the group-V element of the periodic table [phosphorus P, arsenic As, antimony Sb, or bismuth Bi] in a slight amount, conduction electrons are created in a conduction band, so that an n-type silicon crystal is produced. On the other hand, in a case where a silicon crystal is doped with a group-III element [boron B, aluminum Al, gallium Ga, or indium In] in a slight amount, holes are created, so that a p-type silicon crystal is produced.

As methods of introducing the impurity elements properly into the positions of silicon crystal lattices, there have been utilized:

(1) a method wherein a material originally containing a certain amount of impurity element is melted to grow a crystal,

(2) a method wherein a predetermined amount of impurity element is afforded to a crystal surface, and the element is diffused at a high temperature by exploiting a concentration gradient, and

(3) a method wherein the impurity element is ionized and accelerated to inject a predetermined amount of impurity element into silicon, and the element atoms are positioned at the proper lattice points by a heat treatment.

With any method, a silicon substrate having a desired characteristic is prepared by controlling the quantity of the impurity element. Accordingly, it is sufficiently anticipated that when the quantity of the impurity element changes due to irradiation or the like, the electrical characteristic expected to remain unchanged will fluctuate to form the cause of a malfunction.

A threshold voltage $V_{TH}$ which is one of the important characteristics of the MOS transistor has the following relation to the quantity of the impurity element with which silicon is doped:

$$V_{TH} = \phi_{MS} - \frac{Q_{ss}}{C_{ox}} + \phi_F + \frac{\sqrt{2\varepsilon_o \cdot \varepsilon_{si} \cdot q \cdot N(21\phi_F)}}{C_{ox}}$$

where

$\phi_{MS}$: difference between the work functions of a gate electrode material and silicon, $\phi_F$: energy of Fermi level, $\varepsilon_o$: free space permittivity, $\varepsilon_{si}$: relative permittivity of silicon, q: charge of electron, $Q_{SS}$: quantity of stationary charges within an oxide film, $C_{ox}$: capacitance of the oxide film, and N: impurity concentration.

Assuming now that the variation of $V_{TH}$ be given by

$$\Delta V_{TH} = V_{TH}(N_X) - V_{TH}(N_O),$$

then the following holds:

$$\Delta V_{TH} = 2kT\ln\left(\frac{N_X}{N_O}\right) + \frac{\sqrt{2\varepsilon_o \cdot \varepsilon_{si} \cdot q \cdot kT}}{C_{ox}} \times N_O\ln\left(\frac{N_X}{n_I}\right) - N_X\ln\left(\frac{N_O}{n_I}\right)$$

Here, $n_I$ denotes an intrinsic carrier concentration,
$N_O$ the reference quantity of the impurity element, and
$N_X$ the mixed quantity of the impurity element.

By way of example, the quantity of doping of an acceptor introduced when an intrinsic semiconductor body having the carrier concentration $n_I$ is turned into the p-type is the quantity $N_O$, and the quantity of doping of a donor introduced when a part of the p-type semiconductor is turned into the n-type is the quantity $N_X$.

Results obtained by calculating the variation of $\Delta V_{TH}$ versus the deviation of $N_X$ under the assumed conditions of the quantity $N_O = 3 \times 10^{15}/cm^3$ and the thickness of the silicon oxide film $d_{ox} = 1000$ Å are as shown in Figure 2, and the threshold voltage $V_{TH}$ changes by $\pm 0.1$ V or so versus the deviation of 20% in $N_X$. In this manner, the fluctuation of the quantity of the impurity element exerts great influences on characteristics. For this reason, it has heretofore been common practice to pay attention such as controlling the doping quantity of the impurity element by means of ion implantation and to perform controls in a manufacturing process so as to suppress deviations within $\pm 2\%$.

In the following, there will be explained a case where the concentration of the impurity element has changed due to nuclear transformation caused by thermal neutrons.

As stated before, the impurity elements with which a silicon crystal is to be doped in preparing a silicon substrate are the group-V elements (P, As, Sb, Bi) or group-III elements (B, Al, Ga, In) of the periodic table. The abundance ratios of the natural isotopes of the respective elements and the thermal neutron absorption cross sections of the respective isotopes are as listed in Table 1 ('Rika Nenpyō' [Chronological Table of Science], 1982, Table of Isotopes 7th Edition).

TABLE 1

| | | Symbol of element | Mass number | Relative isotopic abundance (%) | Thermal neutron absorption cross section (barns) |
|---|---|---|---|---|---|
| n-type Semi-conductor | group-V Element | P | 31 | 100 | 0.182 |
| | | As | 75 | 100 | 4.42 |
| | | Sb | 121 | 57.25 | 6 |
| | | | 123 | 42.75 | 4 |
| | | Bi | 209 | 100 | 0.02 |
| p-type Semi-conductor | group-III Element | B | 10 | 18.7 | 3832 |
| | | | 11 | 81.3 | 0.005 |
| | | Al | 27 | 100 | 0.231 |
| | | Ga | 69 | 60.2 | 1.71 |
| | | | 71 | 39.8 | 4.62 |
| | | In | 113 | 4.23 | 3 |
| | | | 115 | 95.77 | 200 |

As apparent from Table 1, in case of using a semiconductor device in an atmosphere of thermal neutrons, the changes of electrical characteristics appear most in a semiconductor device which employs a p-type substrate doped with boron B as an impurity element. Particularly at present, only the boron of natural compositions is used in the production of the semiconductor device employing the p-type substrate, and the effect of thermal neutron irradiation of the semiconductor device employing the p-type substrate is great. As indicated in Table 1, naturally existing boron contains about 20% of boron 10 ($B^{10}$) of a mass number 10 which has a thermal neutron absorption cross section of approximately 4000 barns (1 barn=$10^{-24}$ $cm^2$).

Now, letting $\delta$ denote the thermal neutron absorption cross section, $\phi$ denote a thermal neutron flux and $t$ denote an irradiation period of time, and assuming the abundance ratio of $B^{10}$ to be 20%, the change of the number of boron atoms due to the neutron irradiation is expressed by:

$$N_B^t=0.8N_B^o+0.2N_B^o exp(-\delta\phi t)$$

Here, the symbols $N_B^o$ and $N_B^t$ indicate the numbers of boron atoms before the irradiation and after the irradiation for the time $t$ respectively.

Results obtained by calculating the variation of the number of boron atoms attendant upon the irradiation, with the thermal neutron flux being a parameter, are as shown in Figure 3. Under the condition of a present-day light water nuclear reactor (that the mean thermal neutron flux is approximately $3\times10^{13}$ $n/cm^2 \cdot sec$), the boron 10 becomes substantially null due to the irradiation for about 300 days, so that the total amount of boron atoms decreases by about 20%. Besides, when the manufacturing process condition that the fluctuation of the quantity of the impurity element is within ±2% is considered, even a thermal neutron flux of $10^{13}$ $n/cm^2 \cdot sec$ exceeds this criterion in several tens days.

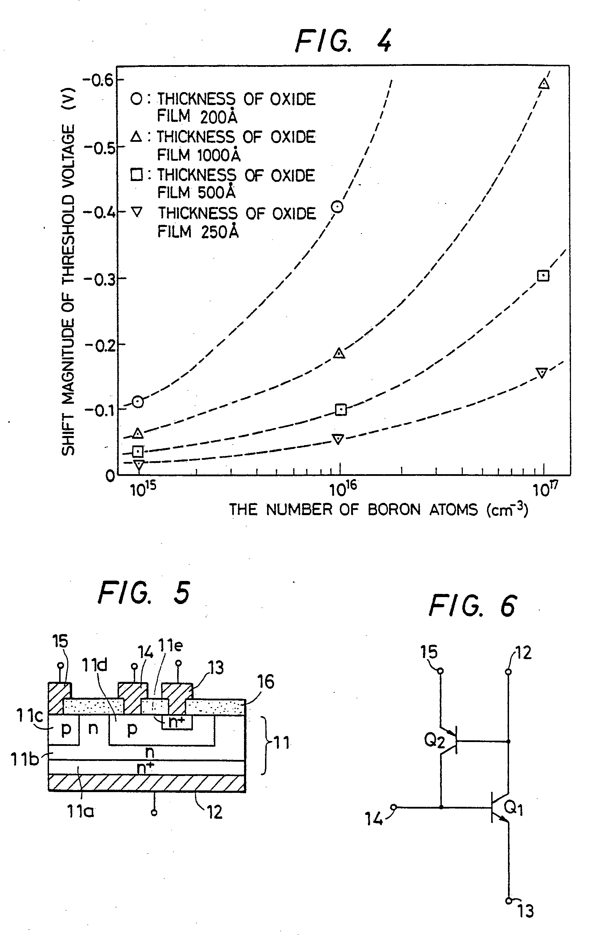

Shown in Figure 4 are the fluctuations of the threshold voltage $V_{TH}$ of the MOS transistor in the case where the number of boron atoms introduced as the impurity element has changed due to the thermal neutron irradiation. In Figure 4, the axis of ordinates represents the shift magnitude of the threshold voltage $V_{TH}$ in the case where among boron atoms introduced before the irradiation, only $B^{10}$ have been extinguished until the total amount of hte boron atoms has decreased to 80% of the amount before the irradiation, that is,

$$\Delta V_{TH}=(\phi_{F^o}+\frac{\sqrt{2\varepsilon_0\varepsilon_{si}qN_0 2 \mid \phi_{F^o} \mid}}{C_{ox}}) -(\phi_{F'}+\frac{\sqrt{2\varepsilon_0\varepsilon_{si}qN_1 2 \mid \phi_{F'} \mid}}{C_{ox}})$$

Here, suffix '0' indicates the value before the irradiation, and suffix '1' the value in the case where the number of boron atoms has decreased by 20% due to the irradiation. On the other hand, the axis of abscissas represents the number of boron atoms contained in the p-type silicon substrate before the irradiation. It is seen from Figure 4 that, as the number of boron atoms before the irradiation is larger, and as the oxide film is thicker, the fluctuation of the electrical characteristic ascribable to the thermal neutron irradiation is greater. By way of example, in the MOS transistor having an oxide film which is 1000 Å thick and which is doped with $10^{17}$ n/cm$^3$ before the irradiation, current begins to flow between the source and the drain with a voltage which is about 0.56 V (about 10%) lower than an anticipated voltage, so that a malfunction occurs. It is accordingly understood that the influence of the irradiation lessens when the concentration of $B^{10}$ contained in the silicon substrate before the irradiation is lower.

Further, $B^{10}$ absorbs the thermal neutron and causes the (n, α) reaction, to undergo nuclear transformation into lithium Li and to give rise to helium He. For this reason, it is sufficiently considered that both the influence by the decrease of the number of boron atoms and the influence by the nuclear-transformed lithium as well as the created helium will be superposed on the fluctuation of the electrical characteristic.

The embodiment of the present invention described above uses $B^{11}$ of smaller thermal neutron absorption cross section as boron atoms to be introduced in preparing the p-type silicon substrate and removes $B^{10}$, thereby intending to alleviate the degration of the electrical characteristic which is induced from the decrease of the impurity element concentration ascribable to the radiation irradiation and to enhance a resistance to the radiation.

Referring to Figure 5, numeral 11 designates a silicon body of the n-type conductivity, the lower major surface of which is doped with an n-type impurity by diffusion so as to form a high-concentration n-type diffused region 11a. The upper major surface of the silicon body 11 is formed with two separate p-type impurity diffused regions 11c and 11d, the latter lid of which is further formed with an n-type impurity diffused region 11e. Numerals 12—15 designate electrodes which are held in ohmic contact with the corresponding diffused regions 11a and 11c—11e. Letting 11b denote a region where no impurity is diffused, the silicon body 11 can be regarded as affording a composite transistor which consists of an n-p-n bipolar transistor $Q_1$ wherein the regions 11a and 11b form a collector, the region 11d forms a base and a region 11e forms an emitter, and a p-n-p bipolar transistor $Q_2$ wherein the region 11c forms an emitter, the region 11b forms a base and the region 11d forms a collector. This situation can be depicted as an equivalent circuit in Figure 6. Numeral 16 in Figure 5 indicates a silicon oxide film for passivation.

As to impurities for use in the silicon body 11 of such construction, bismuth Bi as a donor and gallium Ga of a mass number 69 as an acceptor can be mentioned as an example of combination according to the present invention.

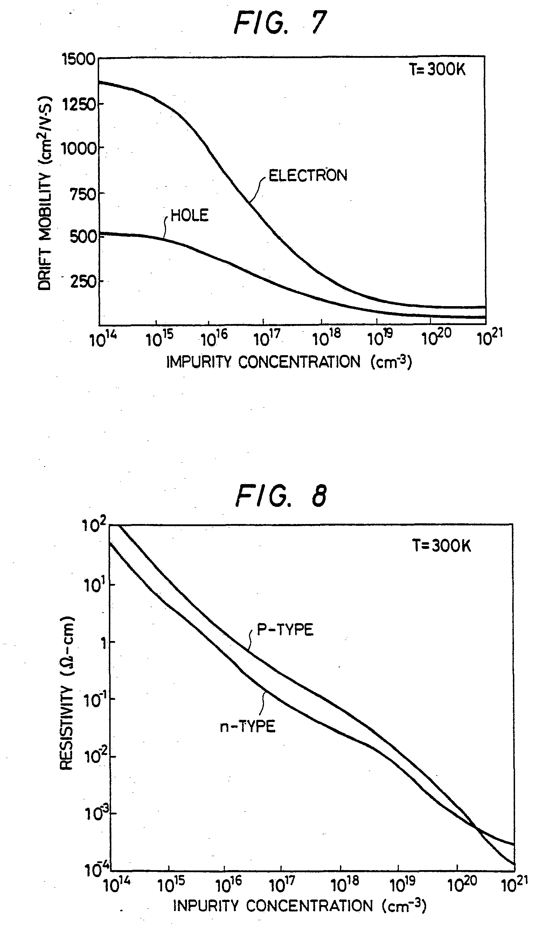

As illustrated in Figures 7 and 8, the impurity concentrations in the silicon body 11 relate with electron and hole drift mobilities and with the resistivities of the respective regions in a thermal equilibrium state.

The fluctuation of the resistivity affects the breakdown voltage and current gain of the transistor.

For example, the grounded-emitter current gain β of the transistor is indicated by the following formula:

$$\beta = \cfrac{1}{\cfrac{\rho_E W_B}{\rho_B L_E} + \cfrac{W_B^2}{2L_B^2}}$$

where ρ denotes the resistivity, W and L denote the width and length of the emitter or base region, and suffixes E and B denote the emitter and base regions.

It is apparent from the above formula that, when the resistivity $\rho_E$ or $\rho_B$ changes, the current gain β fluctuates. Since the resistivities $\rho_E$ and $\rho_B$ are determined by the impurity concentrations, the changes of the impurity concentrations due to the radiation irradiation result in the fluctuation of the current gain β naturally.

In the present invention, accordingly, the impurities of smaller thermal neutron absorption cross sections are employed as the donor and acceptor for forming the regions 11a—11e in Figure 5, as stated before, whereby the fluctuations of the constants of the regions are suppressed to stabilize electrical characteristics.

While the foregoing embodiments have referred to the MOS and bipolar transistors, the present invention is not restricted thereto but it is applicable to all existing semiconductor devices.

In accordance with the present invention, among the isotopes of antimony Sb, boron B, gallium Gj and indium In, ones of smaller thermal neutron absorption cross sections as indicated in Table 1 are selected and employed. For the reason of, e.g., a process such as annealing for diffusion, inevitably the selected impurity is used in combination with another impurity, for example, phosphorus P, arsenic As, bismuth Bi or aluminum Al. Even in that case, it is desirable to employ an impurity of smaller thermal neutron absorption cross section.

According to the present invention, an element which is enriched in an isotope which exhibits a smaller thermal neutron absorption cross section for a nuclear reaction to be noted is used, and hence, the degradation of the electrical characteristics of a semiconductor device attendant upon nuclear transformation can be prevented, so that the invention is effective to enhance the resistance of the semiconductor device to radiation.

**Claims**

1. A radiation-resistant semiconductor device comprising:

a) a semiconductor body (1, 11) which includes at least one region (1, 11a, 11b, 11c) of one conductivity type and at least one region (1b, 11c, 11d) of the opposite conductivity type; and

b) electrodes (2, 3, 4; 13, 14, 15) which are respectively held in ohmic contact with said region of one conductivity type and said region of the opposite conductivity type;

c) at least one of said regions being doped with an impurity for determining the conductivity type, said impurity being an element having more than one natural isotope and being enriched in one of smaller thermal neutron absorption cross section.

2. A radiation-resistant semiconductor device according to claim 1, wherein said impurity for determining the one conductivity type, which is the isotope of smaller thermal neutron absorption cross section, is a member selected from the group consisting of boron B having a mass number of 11, gallium Ga having a mass number of 69 and indium In having a mass number of 113.

3. A radiation-resistant semiconductor device according to claim 1, wherein said impurity for determining the opposite conductivity type, which is the isotope of smaller thermal neutron absorption cross section, is antimony Sb having a mass number of 123.

4. A radiation-resistant semiconductor device according to claim 2, wherein an impurity for determining the opposite conductivity type is a member selected from the group consisting of phosphorus P and bismuth Bi.

5. A radiation-resistant semiconductor device according to claim 3, wherein an impurity for determining the one conductivity type is aluminum Al.

**Patentansprüche**

1. Strahlungsbeständige Halbleiteranordnung mit:

a) einem Halbleiterkörper (1, 11), der wenigstens einen Bereich (1, 11a, 11b, 11c) eines Leitfähigkeitstyps und wenigstens einen Bereich (1b, 11c, 11d) des entgegengesetzten Leitungstyps enthält; und

b) Elektroden (2, 3, 4; 13, 14, 15), die im ohmschen Kontakt mit dem Bereich des einen Leitfähigkeitstyps bzw. mit dem Bereich des entgegengesetzten Leitungstyps gehalten sind;

c) wobei wenigstens einer der Bereiche mit einer Verunreinigung zur Bestimmung des Leitfähigkeitstyps dotiert ist, welche Verunreinigung ein Element mit mehr als einem natürlichen Isotop ist und an einem mit geringerem Thermoneutronen-Absorptionsquerschnitt angereichert ist.

2. Strahlungsbeständige Halbleiteranordnung nach Anspruch 1, wobei die Verunreinigung zur Bestimmung des einen Leitfähigkeitstyps, die das Isotop geringeren Thermoneutronen-Absorptionsquerschnitts ist, ein aus der Gruppe gewähltes Glied ist, die aus Bor B mit einer Massenzahl 11, Gallium Ga mit einer Massenzahl 69 und Indium In mit einer Massenzahl 113 besteht.

3. Strahlungsbeständige Halbleiteranordnung nach Anspruch 1, wobei die Verunreinigung zur Bestimmung des entgegengesetzten Leitfähigkeitstyps, die das Isotop geringeren Thermoneutronen-Absorptionsquerschnitts ist, Antimon Sb mit einer Massenzahl 123 ist.

4. Strahlungsbeständige Halbleiteranordnung nach Anspruch 2, wobei eine Verunreinigung zur Bestimmung des entgegengesetzten Leitfähigkeitstyps ein aus der Gruppe gewähltes Glied ist, die aus Phosphor P und Wismut Bi besteht.

5. Strahlungsbeständige Halbleiteranordnung nach Anspruch 3, wobei eine Verunreinigung zur Bestimmung des einen Leitfähigkeitstyps Aluminium Al ist.

**Revendications**

1. Dispositif à semiconducteurs résistant aux rayonnements, comportant:

a) un corps semiconducteur (1, 11) qui comporte au moins une région (1, 11a, 11b, 11c) possédant un premier type de conductivité et au moins une région (1b, 11c, 11d) possédant le type de conductivité opposé;

b) des électrodes (2, 3, 4; 13, 14, 15) qui sont maintenues respectivement en contact ohmique avec ladite région possédant le premier type de conductivité et ladite région possédant le type de conductivité opposé;

c) au moins l'une desdites régions étant dopée avec une impureté servant à déterminer le type de conductivité, ladite impureté étant un élément possédant plus d'un isotope naturel et étant enrichie pour former un élément possédant une plus petite section efficace d'absorption des neutrons thermiques.

2. Dispositif à semiconducteurs résistant aux rayonnements selon la revendication 1, dans lequel ladite impureté, qui sert à déterminer le premier type de conductivité et l'isotope possédant une plus petite section efficace d'absorption des neutrons thermiques, est un élément choisi parmi le groupe incluant le bore B ayant pour nombre de masse 11, le gallium Ga ayant pour nombre de masse 69 et l'indium in ayant pour nombre de masse 113.

3. Dispositif à semiconducteurs résistant aux rayonnements selon la revendication 1, dans lequel ladite impureté, qui sert à déterminer le type de conductivité opposée est l'isotope possédant une plus petite section efficace d'absorption des neutrons thermiques, est l'antimoine Sb ayant pour nombre de masse 123.

4. Dispositif à semiconducteurs résistant aux rayonnements selon la revendication 2, dans lequel une impureté servant à déterminer le type de conductivité opposé est un élément choisi parmi le groupe incluant le phosphore P et le bismuth Bi.

5. Dispositif à semiconducteurs résistant aux rayonnements selon la revendication 3, dans lequel une impureté servant à déterminer le premier type de conductivité est l'aluminium Al.

## FIG. 1

## FIG. 2

$\Delta VTH$ (V)

IMPURITY CONCENTRATION $(cm^{-3})$

## FIG. 3

THE NUMBER OF BORON ATOMS (RELATIVE VALUE)

O : THERMAL NEUTRON FLUX $10^{13} n/cm^2 \cdot sec$

△ : THERMAL NEUTRON FLUX $3 \times 10^{13} n/cm^2 \cdot sec$

▽ : THERMAL NEUTRON FLUX $10^{14} n/cm^2 \cdot sec$

TIME OF IRRADIATION (DAY)

1

**0 155 576**

## FIG. 4

Graph: vertical axis "SHIFT MAGNITUDE OF THRESHOLD VOLTAGE (V)" from 0 to −0.6; horizontal axis "THE NUMBER OF BORON ATOMS ($cm^{-3}$)" from $10^{15}$ to $10^{17}$.

Legend:
○ : THICKNESS OF OXIDE FILM 200Å
△ : THICKNESS OF OXIDE FILM 1000Å
□ : THICKNESS OF OXIDE FILM 500Å
▽ : THICKNESS OF OXIDE FILM 250Å

## FIG. 5

## FIG. 6

2

## FIG. 7

## FIG. 8